# EUROPEAN PATENT SPECIFICATION

(11) **EP 0 711 104 B1**
(45) Date of publication and mention of the grant of the patent: **08.09.1999**
(21) Application number: 95117099.2
(22) Date of filing: 30.10.1995
(51) Int. Cl.: H05K 3/34, H01L 23/31

(54) **Semiconductor device and method for making same**
Halbleiteranordnung und Verfahren zur Herstellung
Dispositif semi-conducteur et procédé de fabrication

(30) Priority: 01.11.1994 JP 26904594
(43) Date of publication of application: 08.05.1996
(73) Proprietor: MITSUBISHI DENKI KABUSHIKI KAISHA, Chiyoda-ku Tokyo (JP)
(72) Inventor: Washida, Tetsuro, c/o Mitsubishi Denki K.K., Tokyo 100 (JP); Ochi, Katsunori, c/o Mitsubishi Denki K.K., Tokyo 100 (JP); Murasawa, Yasuhiro, c/o Mitsubishi Denki K.K., Tokyo 100 (JP)
(74) Representative: Tiedtke, Harro, Dipl.-Ing.

(56) References cited:
- EP-A- 0 047 195
- DE-A- 4 400 341
- GB-A- 2 260 644
- US-A- 4 866 506
- US-A- 5 177 669
- PROCEEDINGS OF THE 44TH ELECTRONIC COMPONENTS & TECHNOLOGY CONFERENCE, 1-4 MAY 1994, WASHINGTON, DC, 1994 pages 67-74, XP 000479148 F. DJENNAS ET AL. 'Advanced package assembly and manufacturing'
- EDN ELECTRICAL DESIGN NEWS, vol. 39, no. 6, 17 March 1994 NEWTON, MASSACHUSETTS US, pages 27-33, XP 000447774 B. KERRIDGE 'Auto applications drive up single chip's IQ'
- PATENT ABSTRACTS OF JAPAN vol. 12 no. 9 (E-572) [2856] ,12 January 1988 & JP-A-62 169450 (HITACHI) 25 July 1987,

## Description

The present invention relates to a semiconductor device comprising a packaged semiconductor on a circuit substrate, and a method for manufacturing the semiconductor device.

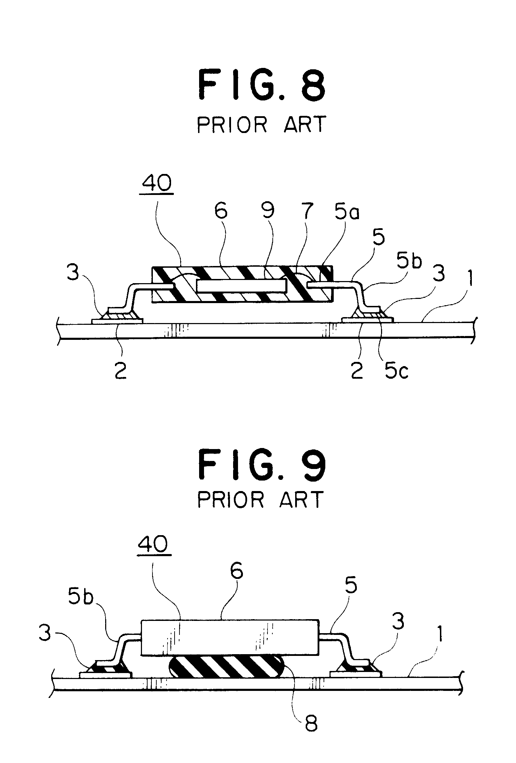

Fig. 8 is a cross-sectional view showing an example of a conventional resin encapsulated semiconductor device, in which a semiconductor element 9 and a lead 5 are electrically connected through a wire 7. The semiconductor element 9, the lead 5 and the wire 7 are encapsulated in an encapsulating resin 6. The portion of the lead 5 encapsulated with the encapsulated resin 6 becomes an inside lead 5a, the portion protruding out of the encapsulating resin 6 forms an outside lead 5b, and the tip 5c of the outside lead 5b is formed in to a gull wing shape. All of the above constitute the resin encapsulated type semiconductor package 40. The tip 5c of the outside lead 5b is soldered to the land 2 of the circuit substrate 1 with solder 3, and the resin encapsulated type semiconductor package 40 and the circuit substrate 1 together constitute the resin encapsulated type semiconductor device.

Recently, due to the change to a thin-type resin encapsulated semiconductor package 40, the thickness of both the encapsulating resin 6 and the lead 5 has decreased immensely leading to a decrease in the strength of the lead 5 of the package in the resin encapsulated type semiconductor device, and thereby the soldered portion of the lead 5 and the lead 5 itself for example are damaged by the thermal or mechanical stress applied to the resin encapsulated type semiconductor device.

In order to solve the above problems, as shown in Fig. 9 as an example from Japanese Patent Laid-Open No. 5-243722, a method was proposed in which the resin encapsulated portion 6 of the resin encapsulated type semiconductor package 40 is fastened on the circuit substrate 1 through an adhesive 8.

By using this method damage to the soldered portion of the lead 5 and damage such as deformation and breaks in the lead 5 itself due to thermal or mechanical stress applied to the resin encapsulated type semiconductor device can be presented.

However, this method still has the drawback that a step for coating the adhesive 8 on the circuit substrate 1 or for injecting the adhesive 8 between the encapsulating resin 6 and the circuit substrate 1 must be added to the production process for the resin encapsulated type semiconductor device.

A similar prior art arrangement is disclosed in document DE-A-4 400 341 of the same applicant.

The foregoing problems are to be solved by the present invention. It is an object of the present invention to provide a resin encapsulated type semiconductor device, which mounts a resin encapsulated type semiconductor package, having improved reliability and which can prevent such damage breaks in the leads in resin encapsulated type semiconductor packages.

It is another object of the present invention to provide a production method for the resin encapsulated type semiconductor device wherein no additional steps are required in the production process.

The above objects are achieved by a semiconductor device according to claim 1, and a production method for manufacturing a semiconductor device according to claim 4. Advantageous further developments of the invention are set out in the dependent claims.

The face on which the circuit of the semiconductor element is not formed is exposed and is not encapsulated by the resin in this resin encapsulated type semiconductor package.

Thinning of the resin encapsulating type semiconductor package can be achieved by this structure. Furthermore, heat dissipation of the package can be more effectively carried out.

In this resin encapsulated type semiconductor device, the semiconductor package is tightly fastened to the dummy land positioned on the circuit substrate. The heat generated from the semiconductor can be dissipated through the bonding material applied to the exposed face of the semiconductor element.

In this embodiment, as the device has excellent durability against thermal and mechanical stress, breaks or damage in the leads of the resin encapsulating type semiconductor package can be prevented. also the heat dissipation characteristics of the semiconductor element improve, and the reliability of the device is enhanced.

In a further embodiment of the present invention, in a resin encapsulated type semiconductor device, the exposed face is formed on the bottom surface of a hole sunk on one of the main faces of the resin of the resin encapsulated type semiconductor package and loading the second bonding material penetrates into said hole so that it penetrates between the exposed face and said dummy land, to tightly fasten the members to each other.

In this resin encapsulated type semiconductor device, the semiconductor package is tightly fastened to the dummy land positioned on the circuit substrate with the bonding material loaded into the hole formed on the main face of the resin.

In this embodiment, as the resin encapsulating type semiconductor package is more tightly fastened to the dummy land provided on the circuit substrate, durability against thermal and mechanical stress is improved.

According to the method for manufacturing a resin encapsulated type semiconductor device, when compared to conventional methods no new materials are required, and also, in the soldering process of the present invention, the solder is coated on both the conventional land and the dummy land at the same time.

In this embodiment, a resin encapsulating type semiconductor device being extremely durable against thermal and mechanical stress can be manufactured without the addition of any new steps to the process.
Fig. 1 is a front view of an embodiment of the resin encapsulated type semiconductor device of the present invention;
Fig. 2 is a cross-sectional view taken along line II - II of Fig. 1;
Fig. 3 is a front view of another embodiment of the resin encapsulated type semiconductor device in the present invention;
Fig. 4 is a cross-sectional view taken along line IV - IV of Fig. 3;
Fig. 5 is a front view of another embodiment of the resin encapsulated type semiconductor device in the present invention;
Fig. 6 is a cross-sectional view of another embodiment of the resin encapsulated type semiconductor device in the present invention;
Fig. 7 is a cross-sectional view of another embodiment of the resin encapsulated type semiconductor device in the present invention;
Fig. 8 is a cross-sectional view of a conventional resin encapsulated type semiconductor device of the prior art; and
Fig. 9 is a cross-sectional view of another conventional resin encapsulated type semiconductor device of the prior art.

### EXAMPLE 1

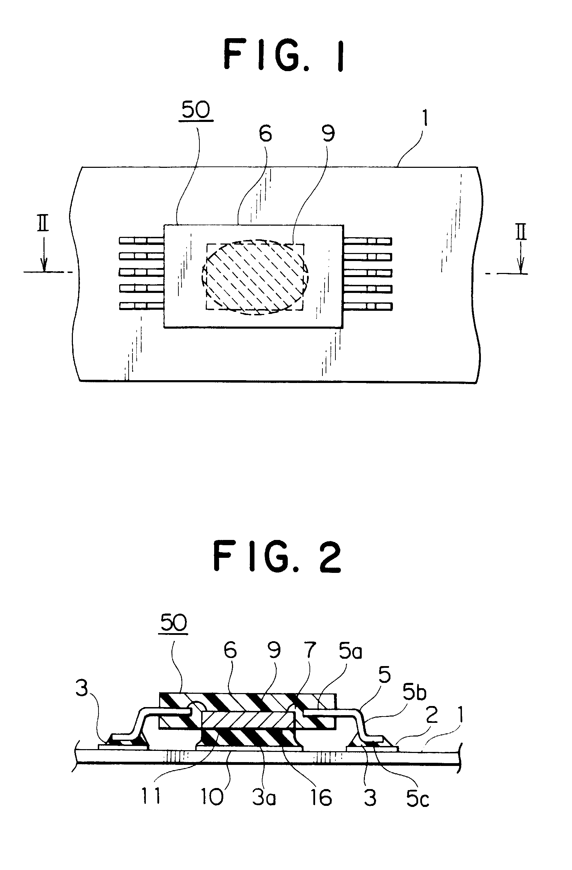

Fig. 1 is a front view of an embodiment of the resin encapsulated type semiconductor device of the present invention, and Fig. 2 is a cross-sectional view taken along line II - II of Fig. 1. In these figures, as the same features are described by the same numerals as those in Fig. 8 previously explained in the prior art section, their explanation will be omitted. The resin encapsulating type semiconductor package 50 in the present invention has an opening 16 forming an exposed face 11 formed by exposing the area of the reverse face of the package where the semiconductor circuit is not formed. The package 50 can be made so as to prevent the encapsulating from penetrating onto the reverse face of the semiconductor element 9 in the encapsulating step, for example, by making a mold come into close contact with the exposed face 11 of the semiconductor element 9.

On the circuit substrate 1, the dummy land 10 is provided under the exposed face 11 at the mounting position of the resin encapsulating type semiconductor package 50. The size and shape of the dummy land 10 are approximately equal to the exposed face 11 of the semiconductor element 9. The exposed face 11 of the resin encapsulating type semiconductor package 50 and the dummy land 10 are tightly fastened to each other by solder 3a (a second bonding material) coated therebetween. Although the area over which solder 3a is coated may be appropriately chosen, it is preferable to over the entire exposed face 11 of the semiconductor element 9 with solder 3a.

In the resin encapsulating type semiconductor device obtained by the above process, as the reverse face of the resin encapsulating type semiconductor package 50 is tightly fastened to the dummy land 10 provided on the circuit substrate 1, breaks or damage in the lead 5 of the resin encapsulating type semiconductor package 50 can be prevented when thermal or mechanical stress is applied to the resin encapsulating type semiconductor device, to enhance the reliability of the device.

According to the structure of this embodiment, no new material is required in the manufacturing process of the resin encapsulating type semiconductor device, and the solder 3a can be provided to the dummy land 10 at the same time the solder 3 (a first bonding material) as is conventionally coated or printed on the land 2. Next, the parts mounting step for mounting the parts including the resin encapsulating type semiconductor. package is carried out; and this is then followed by reflow step wherein the mounted parts are fastend by fusing and solidifying the coated or printed solder. In the reflow step, the solder on the dummy land is also fused, so no additional steps are required in the mounting process of the resin encapsulating type semiconductor package 50.

The thickness of the solder 3a coated or printed on the dummy land 10 is exaggerated in Fig. 2 being shown larger than the actual thickness. The actual height of the exposed face 11 of the semiconductor element 9 of the reverse face of the resin encapsulating type semiconductor package 50 from the circuit substrate 1 is approximately equal to the height of the tip 5c of the outside lead 5b from the circuit substrate 1, thus, the thickness of the solder 3a may be the same as the painted or printed thickness of the solder 3.

This example explains the resin encapsulating type semiconductor package 50 wherein the semiconductor element 9 without a die pad is encapsulated. This example meets with the recent trend of having the die pad acting as a pedestal for the semiconductor element omitted in order to make a thinner resin encapsulating type semiconductor package.

### EXAMPLE 2

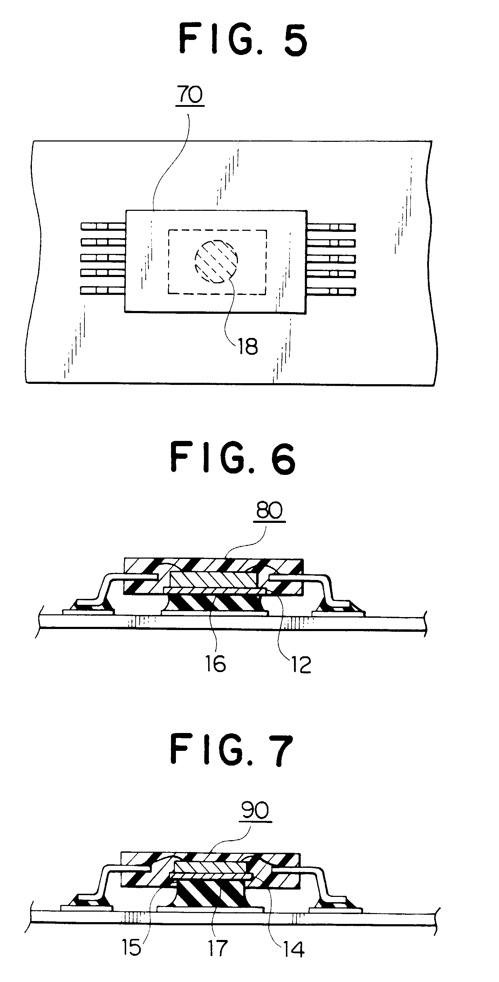

Fig. 6 is a resin encapsulating type semiconductor package having a die pad 12. Similar effects as those found in Example 1 can be confirmed from the resin encapsulating type semiconductor package having such a structure.

### EXAMPLE 3

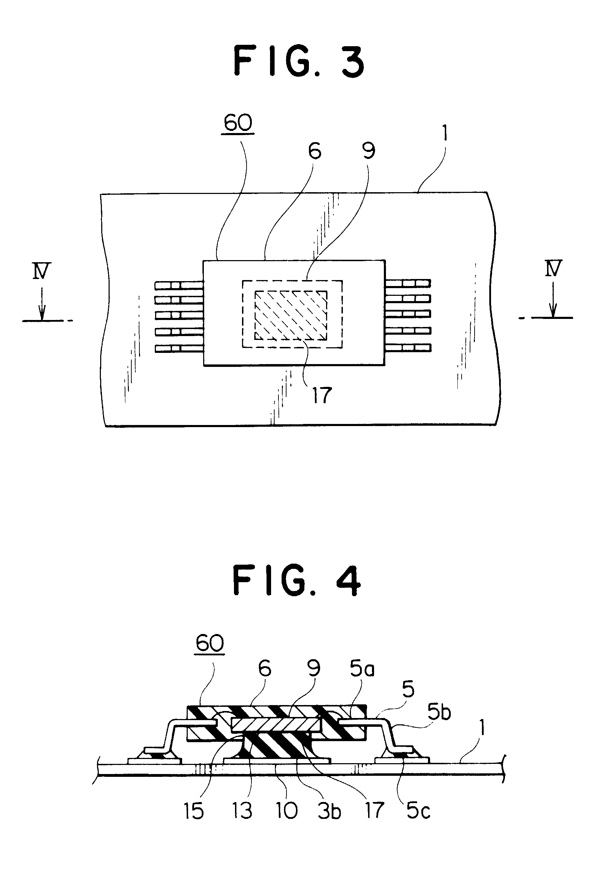

Fig. 3 is a front view of another embodiment of the resin encapsulated type semiconductor device of the present invention, and Fig. 4 is a cross-sectional view taken along line IV - IV of Fig. 3. In a resin encapsulating type semiconductor package 60 mounted on the circuit substrate 1, the semiconductor element 9 is conventionally positioned in the center portion of the encapsulating resin 6, the encapsulating resin is provided with a hole 15 sunk at an appropriate portion of the semiconductor element 9, and an opening 17 forming an exposed face 13 formed by exposing the face on which the circuit is not formed is provided on the bottom face of the hole 15. Solder 3b (a second bonding material) is positioned between the sunk hole 15 and the dummy land 10 and the solder 3b penetrates into the sunk hole 15 so the members are more tightly fastened to each other when compared with example 4.

This resin encapsulating type semiconductor package 60 can be made by using a mold to form the sunk hole 15 of the resin 6 on the reverse face of the semiconductor element. Alternatively, after the resin encapsulating type semiconductor package is conventionally manufactured so that the semiconductor element is completely encapsulated, a resin encapsulating type semiconductor package 70 having the opening 18, which forms the exposed face of the semiconductor element 9 on the reverse face, may be manufactured by shaving out a circular form in, the encapsulating resin 6 on the reverse face of the resin encapsulating type semiconductor package using a file or a cutter as shown in Fig. 5.

### EXAMPLE 4

In this example, as in Embodiment 2, no additional steps are required in the manufacturing process of the resin encapsulating type semiconductor package. Also the bonding strength between the circuit substrate 1 and the resin encapsulating type semiconductor package 60 or the circuit substrate 1 and the resin encapsulating type semiconductor package 70 is improved.

### EXAMPLE 5

Fig. 7 is a resin encapsulating type semiconductor package having a die pad 14. This package has similar effects to those of EXAMPLE 3.

Although the preferred examples of the present invention have been described above. The package comprises not only resin but also at least one of glass, ceramic, and metal.

## Claims

1. A semiconductor device comprising:
a packaged semiconductor comprising
a semiconductor element **(9),**
a plurality of leads **(5, 5a, 5b)** electrically connected to said semiconductor element,
a package **(50; 60; 70; 80; 90)** encapsulating said semiconductor element and said leads, and with
said package having an opening **(16; 17)** forming an exposed face by leaving at least one portion of the face of the semiconductor element on which the circuit is not formed, uncovered by said package; and
a circuit substrate **(1)** on which to mount said packaged semiconductor by its exposed face side;
a plurality of lands **(2)** provided on said circuit substrate in positions corresponding to the tips **(5c)** of said leads;
a dummy land **(10)** provided on said circuit substrate **(1)** in a position corresponding to the mounting position of said packaged semiconductor;
a first bonding material **(3)** placed between said tips **(5c)** of the leads and said lands **(2)** and electrically connecting them together; and
a second bonding material **(3a)** of the same material as the first bonding material placed between said exposed face of said packaged semiconductor and said dummy land **(10),** to tightly fasten them to each other.

2. A semiconductor device in according to claim 1, **wherein**
said exposed face **(13)** is formed on the bottom surface of a hole **(17)** sunk on one of the main faces of said package **(60; 90)** of said packaged semiconductor and loading said second bonding material into said hole so that it penetrates between said exposed face and said dummy land to tightly fasten the members to each other.

3. A semiconductor device according to claim 1, **wherein** said package comprises at least one of the material selected from the group consisting of resin, glass, ceramic and metal.

4. A production method for manufacturing a semiconductor device, comprising:
providing a packaged semiconductor comprising
a semiconductor element **(9),**
a plurality of leads **(5, 5a, 5b)** electrically connected to said semiconductor element,
a package **(50; 60; 70; 80; 90)** encapsulating said semiconductor element and said leads, and with
said package having an opening **(16; 17)** forming an exposed face by leaving at least one portion of the face of the semiconductor element on which the circuit is not formed, uncovered by said package;
a step for forming a plurality of lands **(2)** on a circuit substrate **(1)** in positions corresponding to the tips of the leads;
a step for forming a dummy land **(10)** on said circuit substrate in a position corresponding to the mounting position of said packaged semiconductor;
a solder providing step for coating a first solder **(3)** on said lands **(2)** and a second solder **(3a)** of the same material as the first solder on said dummy land **(10)** of said circuit substrate **(1);**
a parts mounting step for mounting said packaged semiconductor on said circuit substrate **(1);** and
a solder reflow step for fastening said packaged semiconductor to the dummy land **(10)** provided on said circuit substrate **(1)** and the leads **(5, 5b)** to their respective lands **(2),** by heating and cooling said solder.

## Patentansprüche

1. Halbleitervorrichtung mit:
einem Halbleiter in einem Gehäuse mit
einem Halbleiterelement (9),
einer Vielzahl elektrisch mit dem Halbleiterelement verbundener Zuleitungen (5, 5a, 5b),
einem Gehäuse (50; 60; 70; 80; 90), das das Halbleiterelement und die Zuleitungen einschließt, und wobei
das Gehäuse eine Öffnung (16; 17) aufweist, die eine freigelegte Fläche ausbildet, indem zumindest ein Abschnitt der Fläche des Halbleiterelements, auf dem die Schaltung nicht ausgebildet ist, durch das Gehäuse unbedeckt bleibt; und
einem Schaltungssubtsrat (1), auf dem der Halbleiter in dem Gehäuse mit der Seite der freigelegten Fläche angebracht wird;
einer Vielzahl von Anschlußflächen (2), die auf dem Schaltungssubstrat an den den Enden (5c) der Zuleitungen entsprechenden Stellen bereitgestellt sind;
einer Scheinanschlußfläche (10), die auf dem Schaltungssubstrat (1) an einer der Anbringungsstelle des Halbleiters in dem Gehäuse entsprechenden Stelle bereitgestellt ist;
einem ersten Verbindungswerkstoff (3), der zwischen den Enden (5c) der Zuleitungen und den Anschlußflächen (2) angeordnet ist und diese elektrisch miteinander verbindet; und
einem zweiten Verbindungswerkstoff (3a) aus dem gleichen Material wie der erste Verbindungswerkstoff, der zwischen der freigelegten Fläche des Halbleiters in dem Gehäuse und der Scheinanschlußfläche (10) angeordnet ist, damit diese fest aneinander befestigt sind.

2. Halbleitervorrichtung nach Anspruch 1, wobei die freigelegte Fläche (13) auf der Oberfläche des Bodens eines Lochs (17) ausgebildet ist, das in eine der Hauptflächen des Gehäuses (60; 90) des Halbleiters in dem Gehäuse eingelassen ist, und der zweite Verbindungswerkstoff so in das Loch gefüllt wird, daß er zwischen die freigelegte Fläche und die Scheinanschlußfläche zu einer festen Befestigung der Elemente aneinander eindringt.

3. Halbleitervorrichtung nach Anspruch 1, wobei das Gehäuse zumindest einen der Werkstoffe Harz, Glas, Keramik oder Metall aufweist.

4. Herstellungsverfahren zur Herstellung einer Halbleitervorrichtung, mit:
dem Bereitstellen eines Halbleiters in einem Gehäuse mit
einem Halbleiterelement (9),
einer Vielzahl von Zuleitungen (5, 5a, 5b), die elektrisch mit dem Halbleiterelement verbunden sind,
einem Gehäuse (50; 60; 70; 80; 90), das das Halbleiterelement und die Zuleitungen einschließt, und wobei
das Gehäuse eine Öffnung (16; 17) aufweist, die eine freigelegte Fläche ausbildet, indem zumindest ein Abschnitt der Fläche des Halbleiterelements, auf dem die Schaltung nicht ausgebildet ist, durch das Gehäuse unbedeckt bleibt;
einem Schritt zur Ausbildung einer Vielzahl von Anschlußflächen (2) auf einem Schaltungssubstrat (1) an den den Enden der Zuleitungen entsprechenden Stellen;
einem Schritt zur Ausbildung einer Scheinanschlußfläche (10) auf dem Schaltungssubstrat an einer der Anbringungsstelle des Halbleiters in dem Gehäuse entsprechenden Stelle;
einem Schritt zum Bereitstellen von Lötmetall zum Beschichten eines ersten Lötmetalls (3) auf die Anschlußflächen (2) und eines zweiten Lötmetalls (3a) aus dem gleichen Werkstoff wie das erste Lötmetall auf der Scheinanschlußfläche (10) des Schaltungssubstrats (1);
einem Schritt zum Anbringen von Teilen zum Anbringen des Halbleiters in dem Gehäuse auf dem Schaltungssubtrat (1); und
einem Schritt zum Zurückfließen des Lötmetalls zum Befestigen des Halbleiters in dem Gehäuse an die auf dem Schaltungssubstrat (1) bereitgestellte Scheinanschlußfläche (10) und der Zuleitungen (5, 5b) an ihre jeweiligen Anschlußflächen (2), indem das Lötmetall erwärmt und abgekühlt wird.

## Revendications

1. Un dispositif à semiconducteur comprenant :
un semiconducteur monté en boîtier comprenant :
un élément semiconducteur (9),
un ensemble de conducteurs (5, 5a, 5b) connectés électriquement à l'élément semiconducteur,
un boîtier (50; 60; 70; 80; 90) encapsulant l'élément semiconducteur et les conducteurs, et dans lequel
le boîtier comporte une ouverture (16; 17) formant une face à nu, en laissant découverte par le boîtier au moins une partie de la face de l'élément semiconducteur sur laquelle le circuit n'est pas formé; et
un substrat de circuit (1) sur lequel il est prévu de monter le semiconducteur en boîtier, par le côté de sa face à nu;
un ensemble de plages de connexion (2) formées sur le substrat de circuit dans des positions correspondant aux extrémités (5c) des conducteurs;
une plage de connexion fictive (10) formée sur le substrat de circuit (1) dans une position correspondant à la position de montage du semiconducteur en boîtier;
un premier matériau de fixation (3) placé entre les extrémités (5c) des conducteurs et les plages de connexion (2) et les connectant électriquement ensemble; et
un second matériau de fixation (3a) constitué par le même matériau que le premier matériau de fixation, placé entre la face à nu du semiconducteur en boîtier et la plage de connexion fictive (10), pour les fixer fermement l'une à l'autre.

2. Un dispositif à semiconducteur selon la revendication 1, dans lequel
la face à nu (13) est formée sur la surface de fond d'un trou (17) creusé dans l'une des faces principales du boîtier (60; 90) du semiconducteur en boîtier, et le second matériau de fixation est introduit dans ce trou de façon qu'il pénètre entre la face à nu et la plage de connexion fictive, pour fixer fermement ces éléments l'un à l'autre.

3. Un dispositif à semiconducteur selon la revendication 1, dans lequel le boîtier comprend au moins un matériau sélectionné dans le groupe comprenant une résine, un verre, un céramique et un métal.

4. Un procédé de production pour fabriquer un dispositif à semiconducteur, comprenant:
la fourniture d'un semiconducteur en boîtier comprenant :
un élément semiconducteur (9),
un ensemble de conducteurs (5, 5a, 5b) connectés électriquement à l'élément semiconducteur,
un boîtier (50; 60; 70; 80; 90) encapsulant l'élément semiconducteur et les conducteurs, et dans lequel
le boîtier comporte une ouverture (16; 17) formant une face à nu, en laissant découverte par le boîtier au moins une partie de la face de l'élément semiconducteur sur laquelle le circuit n'est pas formé;
une étape pour former un ensemble de plages de connexion (2) sur un substrat de circuit (1), dans des positions correspondant aux extrémités des conducteurs;
une étape pour former une plage de connexion fictive (10) sur le substrat de circuit, dans une position correspondant à la position de montage du semiconducteur en boîtier;
une étape d'application de brasure pour revêtir les plages de connexion (2) avec une première brasure (3) et la plage de connexion fictive (10) du substrat de circuit (1) avec une seconde brasure (3a) constituée par le même matériau que la première brasure;
une étape de montage de composants pour monter le semiconducteur en boîtier sur le substrat de circuit (1); et
une étape de refusion de brasure pour fixer le semiconducteur en boîtier sur la plage de connexion fictive (10) formée sur le substrat de circuit (1), et les conducteurs (5, 5b) à leurs plages de connexion respectives (2), en chauffant et en refroidissant la brasure.
